# EUROPÄISCHE PATENTANMELDUNG

(11) **EP 0 838 988 A2**
(43) Veröffentlichungstag der Anmeldung: **29.04.1998**
(21) Anmeldenummer: 97810717.5
(22) Anmeldetag: 30.09.1997
(51) Int. Cl.: H05K 7/20, H01L 23/473

(54) **Flüssigkeits-Kühlvorrichtung für ein Hochleistungs-Halbleitermodul**

(30) Priorität: 23.10.1996 DE 19643717
(71) Anmelder: Asea Brown Boveri AG, 5401 Baden (CH)
(72) Erfinder: Frey, Toni, Dr., La Jolla, CA 92037 (US); Stuck, Alexander, Dr., 5430 Wettingen (CH); Zehringer, Raymond, Dr., 5444 Künten (CH)
(74) Vertreter: Weibel, Beat

(57) **Zusammenfassung**

Bei einer Flüssigkeits-Kühlvorrichtung (1) für ein Hochleistungs-Halbleitermodul (14), welches eine Mehrzahl von nebeneinander auf einer Kühlfläche (3) angeordneten, wärmeerzeugenden Submodulen (8a-h) enthält, die mit der Kühlfläche (3) stoffschlüssig verbunden sind, wird eine verbesserte Lastwechselfestigkeit dadurch erreicht, dass die Flüssigkeits-Kühlvorrichtung (1) ein Gehäuse (2) aufweist, welches einen von einer Kühlflüssigkeit durchflossenen Flüssigkeitsraum (4) umschliesst, und dessen Oberseite die Kühlfläche (3) bildet, und dass das Gehäuse (2) der Flüssigkeits-Kühlvorrichtung (1) zumindest im Bereich der Kühlfläche (3) aus einem Metall - Kermik Kompositmaterial besteht, dessen thermischer Ausdehnungskoeffizient dem thermischen Ausdehnungskoeffizienten der Keramiksubstrate bzw. der Leistungshalbleiterbauelemente der Submodule (8a-h) angepasst ist und dass im Flüssigkeitsraum (4) der Flüssigkeits-Kühlvorrichtung (1) zusätzliche Mittel (lla-h; 12) zur Verbesserung des Wärmeübergangs zwischen der Kühlfläche (3) und der Kühlflüssigkeit vorgesehen sind.

## Beschreibung

### TECHNISCHES GEBIET

Die vorliegende Erfindung bezieht sich auf das Gebiet der Leistungselektronik. Sie betrifft eine Flüssigkeits-Kühlvorrichtung für ein Hochleistungs-Halbleitermodul, welches eine Mehrzahl von nebeneinander auf einer Kühlfläche angeordneten, wärmeerzeugenden Submodulen enthält, wobei jedes der Submodule wenigstens ein auf einem elektrisch isolierenden Keramiksubstrat aufgebrachtes Leistungshalbleiterbauelement umfasst und auf der Unterseite des Keramiksubstrats mit der Kühlfläche stoffschlüssig verbunden ist, und welche Flüssigkeits-Kühlvorrichtung (1) ein Gehäuse (2) aufweist, das einen von einer Kühlflüssigkeit durchflossenen Flüssigkeitsraum (4) umschliesst und dessen Oberseite die Kühlfläche (3) bildet.

### STAND DER TECHNIK

Hochleistungs-Halbleitermodule sind Komponenten für die Leistungselektronik. Ein Modul beinhaltet in der Regel mehrere Halbleiterbauelemente, die zu einer logischen Funktionseinheit zusammengefasst werden können. Solche Module (z.B. Thyristor-, IGBT- oder Dioden-Module) sind heutzutage im Leistungsbereich bis zu 2500 V und einigen 100 A weit verbreitet und werden vor allem in Industrieantrieben eingesetzt. Beispiele für Module der genannten Art sind aus der EP-A1-0 597 144 oder aus einem Artikel von T. Stockmeier et al., Reliable 1200 Amp 2500 V IGBT Modules for Traction Applications, IEEE IGBT Propulsion Drives Colloquium, London, April 1995, bekannt.

In Traktionsantrieben haben diese Module bisher nur sehr begrenzt Eingang gefunden. Dies liegt unter anderem auch an der geforderten Langzeit-Zuverlässigkeit, die von herkömmlichen Modulen bisher nicht erfüllt wird. Beim heutigen Stand der Technik ist ein wichtiger Ausfallmechanismus die Ermüdung der Lotschichten zwischen dem Substrat, auf dem die Siliziumchips aufgebaut werden, und dem mit dem Modul verbundenen Wasser- bzw. Flüssigkeitskühler. Dies führt schliesslich zu einer Überhitzung der Chips und zum Ablösen der elektrischen Kontakte. Die Erscheinung wird nach einer Anzahl von Lastwechseln beobachtet, bei denen die Chips mittels der selbst erzeugten Verlustwärme im Betrieb auf die maximal zulässige Betriebstemperatur aufgeheizt und dann wieder auf die Kühlwassertemperatur abgekühlt werden. Die maximale Anzahl von Lastwechseln, nach denen der erwähnte Ausfall auftritt, hängt dabei stark von der Kühlertemperatur, dem Temperaturhub und der Geschwindigkeit der Temperaturänderung ab. Insgesamt ist die erreichbare Lastwechselfestigkeit für die Anforderungen im Traktionsbereich viel zu klein, um eine sichere Anwendung zuzulassen.

In der DE 42 44 721 A1 werden Halbleiterventile für elektrische Maschinen angegeben, die eine integrierte Fluid - Kühlanordnung aufweisen. Eine effiziente Kühlung wird u. a. dadurch realisiert, dass der Boden oder Deckel eines Kühlfluidkanals unmittelbar von der Rückseite der Halbleitersubstrate oder ihres keramischen Isolierträgers gebildet wird. Nachteilig an dieser Lösung ist es, dass der Isolierträger bzw. das Halbleitersubstrat eine Doppelfunktion als elektrischer Isolator und Wärmeleiter erfüllen muss. Dadurch wird die Materialwahl sehr stark, in erster Linie auf Isolationskeramiken, eingeschränkt oder es müssen Kompromisse hinsichtlich der Wärmeleitfähigkeit hingenommen werden. Da ferner die Wärmeableitung vollständig über den Isolierträger erfolgt, ist dieser zur Vergrösserung der Austauschfläche sehr grossflächig bzw. breit dimensioniert. Andererseits wird die Wärme von den kleinflächigen Halbleiterelementen sehr lokal produziert und nachweislich beim Durchgang durch das Halbleitersubstrat und den Isolierträger nur geringfügig lateral gespreizt. In dieser Anordnung kann dehalb nur schwerlich eine ausreichende Kühlleistung erreicht werden. Darüberhinaus ist der Kühlkanal relativ aufwendig aus mehreren Materialien zusammengebaut, die zudem unterschiedliche und insbesondere vom Isolierträger differierende Ausdehnungskoeffizienten aufweisen können. Daher wird die Kühleffizienz, thermische Belastbarkeit und Lebensdauer solcher Module unbefriedigend sein.

### DARSTELLUNG DER ERFINDUNG

Es ist daher Aufgabe der Erfindung, eine Flüssigkeits-Kühlvorrichtung für Hochleistungs-Halbleitermodule zu schaffen, welche die Lastwechselfestigkeit der Module drastisch erhöht. Die Aufgabe wird bei einer Vorrichtung der eingangs genannten Art dadurch gelöst, dass die Flüssigkeits-Kühlvorrichtung ein Gehäuse aufweist, welches zumindest im Bereich der Kühlfläche (3) aus einem Metall - Keramik - Kompositmaterial gegossen ist, dessen thermischer Ausdehnungskoeffizient dem thermischen Ausdehnungskoeffizienten der Keramiksubstrate bzw. der Leistungshalbleiterbauelemente der Submodule (8a-h) angepasst ist, und dass im Flüssigkeitsraum (4) der Flüssigkeits-Kühlvorrichtung (1) zusätzliche Mittel (11a-h; 12) zur Verbesserung des Wärmeübergangs zwischen der Kühlfläche (3) und der Kühlflüssigkeit vorgesehen sind.

Die Erfindung geht von der Erkenntnis aus, dass durch eine Anpassung der thermischen Ausdehnungskoeffizienten der Unterlage, die als Kühlungsfläche dient, und mit der die Submodule stoffschlüssig verbunden (z.B. verlötet) sind, an die thermischen Ausdehnungskoeffizienten der Submodule die thermomechanischen Spannungen verringert und damit die Ermüdung der stoffschlüssigen Verbindung verhindert oder stark herabgesetzt werden kann. In konventionellen Modulen sind dagegen die Kühlvorrichtungen typischerweise aus üblichen Metallegierungen wie Aluminium oder Kupfer gefertigt, die einen hohen thermischen Ausdehnungskoeffizienten von ca. 15-23 ppm/K haben, der schlecht mit den thermischen Ausdehnungskoeffizienten vom Silizium der Chips und der Keramiksubstrate harmoniert, die im Bereiche von nur einigen ppm/K liegen.

Gemäss einer ersten bevorzugten Ausführungsform der Erfindung wird der thermische Ausdehnungskoeffizient des Gehäusematerials kleiner als 10 ppm/K, vorzugsweise kleiner 7 ppm/K, gewählt. Damit wird eine Anpassung im thermischen Ausdehnungskoeffizienten der stoffschlüssig verbundenen Teile erreicht, durch welche die thermo-mechanischen Spannungen soweit reduziert werden, dass eine Ermüdung der Verbindung praktisch verhindert wird. Besonders günstig ist es, wenn gemäss einer Weiterbildung dieser Ausführungsform als Gehäusematerial ein Siliziumkarbid-Kompositmaterial, vorzugsweise Aluminium-Siliziumkarbid (AlSiC) oder Kupfer-Siliziumkarbid (CuSiC), die einen thermischen Ausdehnungskoeffizienten von 5-7 ppm/K aufweisen, verwendet wird, und das Gehäuse aus diesem Material gegossen ist. Hierdurch kann, wenn die Gussform entsprechend ausgebildet wird, auf einfache Weise eine optimierte Kühlstruktur realisiert werden, die in ihren thermo-mechanischen Eigenschaften den Si-Chips und dem Keramiksubstrat der Submodule optimal angepasst ist.

Grundsätzlich ist es denkbar, dass das gesamte Gehäuse der Kühlvorrichtung aus dem hinsichtlich des thermischen Ausdehnungskoeffizienten angepassten Material, insbesondere dem o.g. Kompositmaterial, besteht. Wenn jedoch die Kühlstruktur der Vorrichtung so ausgebildet wird, dass die Rückseite des Kühlers nicht mehr signifikant zur Kühlung beiträgt, kann gemäss einer alternativen Ausführungsform der der Kühlfläche gegenüberliegende Gehäuseboden aus einem anderen Material, vorzugsweise aus einem Kunststoff, bestehen. Hierdurch können die Kosten der Vorrichtung deutlich gesenkt werden.

Eine weitere bevorzugte Ausführungsform der Erfindung zeichnet sich dadurch aus, dass im Flüssigkeitsraum der Vorrichtung zusätzliche Mittel zur Verbesserung des Wärmeübergangs zwischen der Kühlfläche und der Kühlflüssigkeit vorgesehen sind, dass die zusätzlichen Mittel eine Mehrzahl von Zapfen umfassen, welche von der Kühlfläche her in den Flüssigkeitsraum hineinragen, dass die Zapfen aus demselben Material bestehen wie die Kühlfläche, und dass die Zapfen zusammen mit der Kühlfläche einstückig ausgebildet sind. Der thermische Widerstand der Kühlstruktur kann dann durch geeignete Wahl der Zapfendurchmesser, des Abstandes der Zapfen untereinander, und der Zapfenhöhe für einen gegebenen Kühlmittelfluss optimiert werden. Es sei an dieser Stelle angemerkt, dass die Verwendung derartiger Zapfen bei einer Kühlvorrichtung für Leistungshalbleiter an sich bekannt ist (siehe z.B. die DE-C2-40 17 749).

Besonders günstige Kühlverhältnisse ergeben sich, wenn gemäss einer Weiterbildung dieser Ausführungsform die Zapfen zylindrisch ausgebildet und mit ihrer Zylinderachse senkrecht zur Kühlfläche orientiert sind, und die Zapfen mit einer hexagonalen Symmetrie angeordnet sind.

Im Allgemeinen wird die Wärme bei einem Modul nicht gleichmässig über die gesamte Kühlfläche, sondern lokal an mehreren Orten konzentriert durch die Submodule in den Kühler abgeführt. Untersuchungen haben gezeigt, dass die Wärmespreizung im Kühler, d.h., die von dem Ort der Submodule ausgehenden seitliche Verteilung der Wärme, gering ist, und dass es deshalb genügt, wenn im Wesentlichen die Submodulbereiche gekühlt werden. Es ist daher gemäss einer weiteren bevorzugten Ausführungsform vorgesehen, dass die Zapfen in Zapfengruppen zusammengefasst sind, und dass jedem der Submodule eine Zapfengruppe zugeordnet ist. Die Kühlung kann dann auf einen Bereich beschränkt werden, der an jedem Rand etwas (vorzugsweise ca. 4 mm) grösser ist als die Submodule. Wird demgegenüber eine grössere Fläche gekühlt, trägt das zusätzliche Wasser nicht zur Kühlung bei, sondern erhöht nur den Durchfluss durch den Kühler.

Aus diesem Grunde ist weiterhin vorteilhaft, wenn Mittel vorgesehen sind, um den Fluss der Kühlflüssigkeit im Flüssigkeitsraum im wesentlichen auf die Bereiche der Zapfengruppen zu beschränken. Wenn die Kühlvorrichtung aus Metall-Keramik-Kompositen gegossen wird, kann die Kühlfläche ohne grossen Aufwand noch zusätzlich strukturiert werden. Indem alle Flächen, die nicht zur Kühlung beitragen, vom Kühlmittelfluss ausgeschlossen werden, ist es möglich, bei gegebenem äusseren Fluss die Kühlereffizienz nochmals zu steigern.

### KURZE ERLÄUTERUNG DER FIGUREN

Die Erfindung soll nachfolgend anhand von Ausführungsbeispielen im Zusammenhang mit der Zeichnung näher erläutert werden. Es zeigen
- Fig. 1: in der perspektivischen Seitenansicht ein Ausführungsbeispiel für ein Hochleistungs-Halbleitermodul mit Flüssigkeits-Kühlvorrichtung nach der Erfindung;
- Fig. 2: den Schnitt durch das Modul gemäss Fig. 1 in der Ebene II-II, und
- Fig. 3: den Schnitt durch das Modul gemäss Fig. 2 entlang der Linie III-III.

### WEGE ZUR AUSFÜHRUNG DER ERFINDUNG

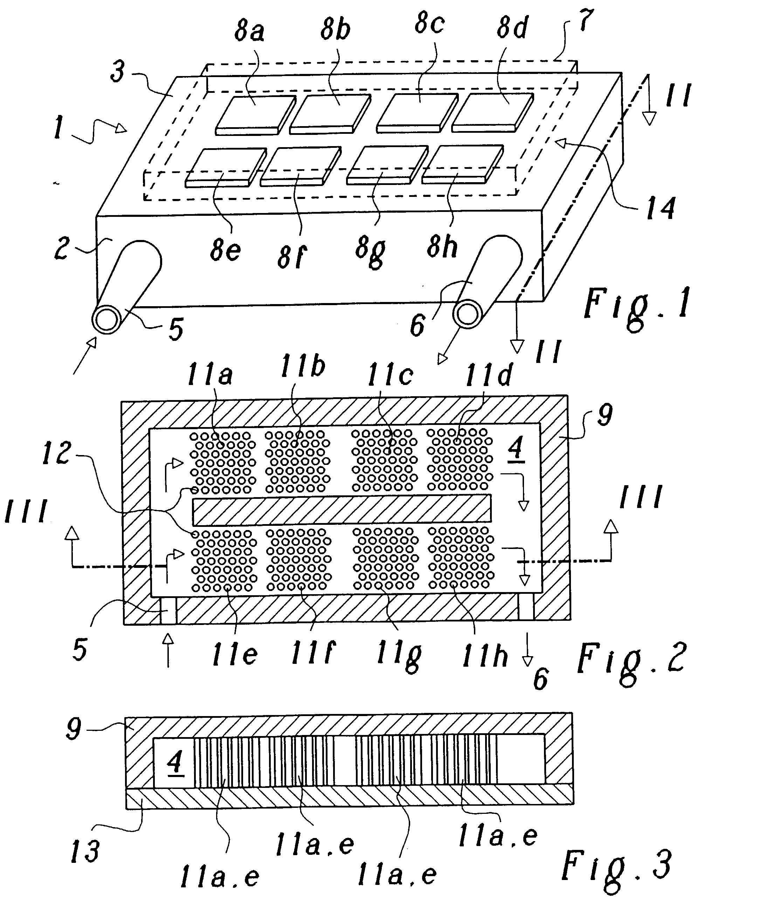

In Fig. 1 ist ein Ausführungsbeispiel für ein Hochleistungs-Halbleitermodul 14 mit Flüssigkeits-Kühlvorrichtung 1 nach der Erfindung in perspektivischer Seitenansicht dargestellt. Das Hochleistungs-Halbleitermodul 14 umfasst eine Mehrzahl von separaten, nebeneinander auf einer Kühlfläche 3 angeordneten Submodulen 8a-8h, die zur Vereinfachung ohne elektrische Verbindungsleitungen und Anschlüsse wiedergegeben sind. Die Submodule 8a-8h des Moduls 14 sind in der Regel von einem Modulgehäuse 7 umgeben, welches in Fig. 1 nur gestrichelt eingezeichnet ist.

Die einzelnen Submodule 8a-8h enthalten Hochleistungs-Silizium-Halbleiterbauelemente in Chipform, z.B. Thyristorchips, Diodenchips, IGBT-Chips oder dgl.. Die Chips sind zusammen mit elektrischen Anschlussleitungen auf einem isolierenden Keramiksubstrat untergebracht, welches seinerseits mit der Kühlfläche 3 stoffschlüssig verbunden, insbesondere aufgelötet ist. Die Submodule 8a-8h sind untereinander aus Gründen der Isolierung und Wärmeverteilung durch Zwischenräume getrennt.

Die Flüssigkeits-Kühlvorrichtung 1 umfasst ein geschlossenes (im Beispiel der Fig. 1 quaderförmiges) Gehäuse 2, welches einen von einer Kühlflüssigkeit durchflossenen Flüssigkeitsraum 4 (Fig. 2) umschliesst, und dessen Oberseite die Kühlfläche 3 bildet. Die Kühlflüssigkeit - in der Regel Wasser - wird dem Flüssigkeitsraum 4 in Richtung der eingezeichneten Pfeile durch einen Einlass 5 zugeführt, und die erwärmte Flüssigkeit durch einen Auslass 6 wieder abgeführt. Anstelle eines einzelnen Ein- und Auslasses können selbstverständlich mehrere Ein- und Auslässe an der Vorrichtung 1 verteilt angeordnet sein.

Unterhalb der Bereiche, in denen die Submodule 8a-8h auf die Kühlfläche 3 aufgelötet sind, ragen, von der Kühlfläche 3 ausgehend, zylindrische, in hexagonaler Symmetrie angeordnete Zapfen 12 in den Flüssigkeitsraum 4. Die Zapfen 12 sind dabei zu Zapfengruppen lla-llh zusammengefasst, wobei jedem Submodul 8a-8h jeweils eine Zapfengruppe 11a-11h zugeordnet ist. Da die Zapfen 12 mit der Kühlfläche 3 zusammen durch Giessen des Gehäuses 2 aus einem Metall-Keramik-Kompositmaterial, vorzugsweise Aluminium-Siliziumkarbid (AlSiC) oder Kupfer-Siliziumkarbid (CuSiC), einstückig hergestellt werden und den Wärmeübergang zwischen Gehäuse 2 und Kühlflüssigkeit wesentlich vergrössern, bilden die einzelnen Zapfengruppen 11a-11h innerhalb der Kühlvorrichtung 1 Bereiche stark verringerten Wärmewiderstands, die direkt unterhalb der Submodule liegen und über diese randseitig etwas überstehen. Die Kühlung erfolgt auf diese Weise mit einem optimierten Flüssigkeits-Fluss, der auf die zu kühlenden Kernbereiche unterhalb der Submodule beschränkt ist, dort aber einen besonders guten Wärmeübergang vorfindet. Eine weitere Verbesserung der Kühleffizienz wird erreicht, wenn die Zwischenräume zwischen den Submodul-Bereichen soweit wie möglich für den Kühlstrom gesperrt werden, wie dies in Fig. 2 durch eine Zwischenwand 10 zwischen den Submodulreihen erfolgt. Die Zwischenwand 10 kann auf einfache Weise zusammen mit den Zapfen 12 beim Giessen des Gehäuses 2 erzeugt werden.

Wie bereits eingangs erwähnt kann der thermische Widerstand Rₜₕ durch geeignete Wahl der Zapfendurchmesser, des Zapfenabstandes und der Zapfenhöhe optimiert werden. Setzt man dabei als zusätzliche Randbedingung für die Höhe der Zapfen 12 fest, dass die Rückseite des Kühlers nicht mehr signifikant zur Kühlung beiträgt, kann die Rückseite des Kühlers, nämlich der Gehäuseboden gemäss Fig. 3, aus Kunststoff hergestellt und mit dem übrigen Gehäuse verklebt werden. Es sei an dieser Stelle darauf hingewiesen, dass bei Modulen mit entsprechend reduzierter Verlustleistung die Zapfenstruktur auf die Kunststoffseite des Kühlers gelegt werden kann. Die metallische (AlSiC, CuSiC) Seite des Kühlers reduziert sich dann auf eine einfache Platte, die wesentlich kostengünstiger hergestellt werden kann. Es ist auch anzumerken, dass es nicht notwendigerweise Zapfen sein müssen, welche den Wärmeübergang verbessern. Es können auch beliebige Strukturen sein, solange sie die Wärme genügend abführen können und in AlSiC (bzw. CuSiC) herstellbar sind. Es sind insbesondere einfachere Strukturen wie z.B. längliche Rippen denkbar.

Versuche mit einer erfindungsgemässen, gegossenen Kühlerstruktur (mit Zapfengruppen) aus AlSiC haben ergeben, dass bei einem Kühlmittelfluss von 4 l/m ein thermischer Widerstand von ca. 8 K/kW erreicht werden kann. Dies entspricht einer Verbesserung von 13% gegenüber einem konventionellen Kühler aus Aluminium. Temperaturwechselversuche haben bestätigt, dass die verringerte thermische Ausdehnung des Kompositkühlers zu einer deutlichen Verringerung der Lotermüdung und damit zu einer Verbesserung der Lastwechselfestigkeit führt.

### BEZEICHNUNGSLISTE

- 1: Flüssigkeits-Kühlvorrichtung
- 2: Gehäuse (Kühlvorrichtung)
- 3: Kühlfläche
- 4: Flüssigkeitsraum
- 5: Einlass
- 6: Auslass
- 7: Modulgehäuse
- 8a-h: Submodul
- 9: Gehäusewand
- 10: Zwischenwand
- 11a-h: Zapfengruppe
- 12: Zapfen
- 13: Gehäuseboden
- 14: Hochleistungs-Halbleitermodul

## Patentansprüche

1. Flüssigkeits-Kühlvorrichtung (1) für ein Hochleistungs-Halbleitermodul (14), welches eine Mehrzahl von nebeneinander auf einer Kühlfläche (3) angeordneten, wärmeerzeugenden Submodulen (8a-h) enthält, wobei jedes der Submodule (8a-h) wenigstens ein auf einem elektrisch isolierenden Keramiksubstrat aufgebrachtes Leistungshalbleiterbauelement umfasst und auf der Unterseite des Keramiksubstrats mit der Kühlfläche (3) stoffschlüssig verbunden ist, und welche Flüssigkeits-Kühlvorrichtung (1) ein Gehäuse (2) aufweist, das einen von einer Kühlflüssigkeit durchflossenen Flüssigkeitsraum (4) umschliesst und dessen Oberseite die Kühlfläche (3) bildet, dadurch gekennzeichnet, dass das Gehäuse (2) der Flüssigkeits-Kühlvorrichtung (1) zumindest im Bereich der Kühlfläche (3) aus einem Metall - Keramik - Kompositmaterial gegossen ist, dessen thermischer Ausdehnungskoeffizient dem thermischen Ausdehnungskoeffizienten der Keramiksubstrate bzw. der Leistungshalbleiterbauelemente der Submodule (8a-h) angepasst ist, und dass im Flüssigkeitsraum (4) der Flüssigkeits-Kühlvorrichtung (1) zusätzliche Mittel (11a-h; 12) zur Verbesserung des Wärmeübergangs zwischen der Kühlfläche (3) und der Kühlflüssigkeit vorgesehen sind.

2. Flüssigkeits-Kühlvorrichtung nach Anspruch 1, dadurch gekennzeichnet, dass der thermische Ausdehnungskoeffizient des Gehäusematerials kleiner als 10 ppm/K, vorzugsweise kleiner 7 ppm/K, beträgt.

3. Flüssigkeits-Kühlvorrichtung nach Anspruch 2, dadurch gekennzeichnet, dass als Gehäusematerial ein Siliziumkarbid-Kompositmaterial, vorzugsweise Aluminium-Siliziumkarbid (AlSiC) oder Kupfer-Siliziumkarbid (CuSiC), verwendet wird, und dass das Gehäuse (2) aus diesem Material gegossen ist.

4. Flüssigkeits-Kühlvorrichtung nach einem der Ansprüche 1 bis 3, dadurch gekennzeichnet, dass das gesamte Gehäuse (2) der Kühlvorrichtung (1) aus dem hinsichtlich des thermischen Ausdehnungskoeffizienten angepassten Material besteht.

5. Flüssigkeits-Kühlvorrichtung nach einem der Ansprüche 1 bis 3, dadurch gekennzeichnet, dass der der Kühlfläche (3) gegenüberliegende Gehäuseboden (13) aus einem anderen Material, vorzugsweise aus einem Kunststoff, besteht.

6. Flüssigkeits-Kühlvorrichtung nach einem der Ansprüche 1 bis 5, dadurch gekennzeichnet, dass die zusätzlichen Mittel (11a-h; 12) eine Mehrzahl von Zapfen (12) umfassen, welche von der Kühlfläche (3) her in den Flüssigkeitsraum (4) hineinragen.

7. Flüssigkeits-Kühlvorrichtung nach Anspruch 6, dadurch gekennzeichnet, dass die Zapfen (12) aus demselben Material bestehen wie die Kühlfläche (3), und dass die Zapfen (12) zusammen mit der Kühlfläche (3) einstückig ausgebildet sind.

8. Flüssigkeits-Kühlvorrichtung nach einem der Ansprüche 6 und 7, dadurch gekennzeichnet, dass die Zapfen (12) zylindrisch ausgebildet und mit ihrer Zylinderachse senkrecht zur Kühlfläche (3) orientiert sind.

9. Flüssigkeits-Kühlvorrichtung nach einem der Ansprüche 6 bis 8, dadurch gekennzeichnet, dass die Zapfen (12) mit einer hexagonalen Symmetrie angeordnet sind.

10. Flüssigkeits-Kühlvorrichtung nach einem der Ansprüche 6 bis 9, dadurch gekennzeichnet, dass die Zapfen (12) in Zapfengruppen (11a-h) zusammengefasst sind, und dass jedem der Submodule (8a-h) eine Zapfengruppe (11a-h) zugeordnet ist.

11. Flüssigkeits-Kühlvorrichtung nach Anspruch 10, dadurch gekennzeichnet, dass Mittel (10) vorgesehen sind, um den Fluss der Kühlflüssigkeit im Flüssigkeitsraum (4) im wesentlichen auf die Bereiche der Zapfengruppen (11a-h) zu beschränken.
